(19) Europäisches Patentamt
European Patent Office
Office européen des brevets

(11) **EP 3 796 542 A1**

(12) **DEMANDE DE BREVET EUROPEEN**

(43) Date de publication:
**24.03.2021 Bulletin 2021/12**

(51) Int Cl.:
***H02N 2/18*** (2006.01)  ***H01L 41/113*** (2006.01)

(21) Numéro de dépôt: **20196518.3**

(22) Date de dépôt: **16.09.2020**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **17.09.2019 FR 1910240**

(71) Demandeurs:
• **Commissariat à l'énergie atomique et aux énergies alternatives
75015 Paris (FR)**

• **Université Savoie Mont Blanc
73000 Chambéry (FR)**

(72) Inventeurs:
• **GIBUS, David
38054 GRENOBLE CEDEX 09 (FR)**
• **BADEL, Adrien
73340 LESCHERAINES (FR)**
• **FREYCHET, Olivier
38054 GRENOBLE CEDEX 09 (FR)**
• **GASNIER, Pierre
38054 GRENOBLE CEDEX 09 (FR)**

(74) Mandataire: **Brevalex
95, rue d'Amsterdam
75378 Paris Cedex 8 (FR)**

(54) **DISPOSITIF DE CONVERSION D'ENERGIE MECANIQUE EN ENERGIE ELECTRIQUE FONCTIONNANT SUR UNE GAMME DE FREQUENCE DE VIBRATION ELARGIE**

(57) Dispositif de conversion d'énergie mécanique en énergie électrique comportant un support (2), une structure (S1) suspendue au support par encastrement par une première extrémité longitudinale (4.1) et comportant une masse (M) fixée à une deuxième extrémité longitudinale (4.2), deux couches en matériau piézoélectriques (12, 14) s'étendant entre la première extrémité longitudinale (4.1) et la deuxième extrémité longitudinale (4.2) de la structure (S1) et disposées de sorte que, lorsque la masse (M) bouge, les couche sont déformées en flexion, des électrodes (E1, E2) de part et d'autre de la couche en matériau piézoélectrique (12, 14), dans lequel la structure (S1) comporte des éléments transversaux (16, 18) solidaires des couche en matériau piézoélectrique (12, 14) s'étendant transversalement par rapport la direction longitudinale (X) de la structure sur une longueur au moins égale à la moitié de la dimension transversale (L) des couches en matériau piézoélectrique (12, 14).

FIG.1B

**Description**

**DOMAINE TECHNIQUE ET ÉTAT DE LA TECHNIQUE ANTÉRIEURE**

La présente invention se rapporte à un dispositif de conversion de vibrations mécaniques en énergie électrique fonctionnant sur une gamme de fréquence de vibration élargie.

On cherche de plus en plus à pouvoir à récupérer l'énergie mécanique perdue, notamment les vibrations, pour produire de l'électricité. Par exemple, il peut s'agir des vibrations d'un moteur d'avion ou de voiture lors de son fonctionnement ou des vibrations générées lors d'un déplacement.

Pour cela il est connu d'utiliser des dispositifs comportant un matériau piézoélectrique qui, lorsqu'il est déformé par exemple sous l'effet des vibrations, génère de l'électricité.

Un tel dispositif peut comporter une structure vibrante comprenant une poutre encastrée à une extrémité longitudinale dans un support et une masse fixée à l'autre extrémité longitudinale, deux couches en matériau piézoélectrique sur les deux faces de la poutre et des électrodes pour collecter les charges électriques générées. Lorsque l'environnement subit des vibrations, la masse oscille et les couches en matériau piézoélectrique sont déformées, générant des charges électriques qui sont collectées.

Une telle structure vibrante présente une fréquence de résonance définie par ses caractéristiques mécaniques. Cette structure présente l'inconvénient d'être sélective en fréquence, i.e. elle assure une conversion des vibrations mécaniques à des fréquences proches de la fréquence de résonance de la structure. Elle n'est donc pas adaptée à une application pour des systèmes vibrant sur une gamme de fréquence étendue.

**EXPOSÉ DE L'INVENTION**

C'est par conséquent un but de la présente invention d'offrir un dispositif de conversion de l'énergie mécanique en énergie électrique dont le fonctionnement sur une large gamme de fréquence est amélioré.

Le but énoncé ci-dessus est atteint par un dispositif de conversion de vibrations mécaniques en électricité comportant un support, une structure suspendue comportant au moins une poutre encastrée au support par une extrémité, et une masse fixée à l'autre extrémité de la poutre, un matériau piézoélectrique sur au moins une des faces de la poutre de sorte à subir une flexion lors de la déformation de la poutre, et au moins un élément transversal s'étendant sensiblement transversalement par rapport à la direction de la poutre sur au moins la moitié de la largeur du matériau piézoélectrique.

Le au moins un élément transversal limite donc la déformation transversale de la structure tout en permettant une déformation en flexion de la structure, le couplage électromécanique de la structure est alors augmenté, ce qui accroit la capacité à adapter la fréquence de résonance de la structure à s'adapter aux modifications de la fréquence de vibration de l'environnement. Ainsi on réalise un dispositif ajustable en fréquence, permettant d'élargir la bande de fréquence des vibrations récupérables.

Grâce à l'invention, au moyen d'un circuit de commande il est possible de commander la fréquence de résonance de la structure de sorte qu'elle soit proche de la fréquence de vibration du support, ce qui permet d'optimiser la récupération d'énergie

De manière préférée, le au moins un élément transversal est rigide et présente une dimension réduite dans la direction longitudinale de la structure, afin de limiter au mieux la déformation transversale de la structure tout en réduisant l'impact sur la déformation en flexion de la structure.

Par exemple, le dispositif comporte des éléments transversaux de part et d'autre de la fibre neutre de la poutre.

Avantageusement, les éléments transversaux sont répartis le long de la structure.

Les éléments transversaux présentent de préférence une rigidité élevée. De plus ils présentent de préférence une dimension faible dans la direction de la longueur de la structure pour limiter leur effet sur la déformation longitudinale.

La présente invention a alors pour objet un dispositif de conversion d'énergie mécanique en énergie électrique comportant un support, une structure s'étendant selon une direction longitudinale, ladite structure étant suspendue au support par encastrement par une première extrémité longitudinale et comportant une masse fixée à une deuxième extrémité longitudinale, au moins une couche en matériau piézoélectrique s'étendant au moins en partie entre la première extrémité longitudinale et la deuxième extrémité longitudinale de la structure et disposée de sorte que, lorsque la masse bouge dans une direction orthogonale à la direction longitudinale, la couche est déformée en flexion, des électrodes de part et d'autre de la couche en matériau piézoélectrique. La structure comporte au moins un élément transversal solidaire de la couche en matériau piézoélectrique s'étendant transversalement par rapport la direction longitudinale sur une longueur au moins égale à la moitié de la dimension transversale de la couche en matériau piézoélectrique.

L'encastrement de la structure au support, i.e. la liaison encastrement entre la structure et le support, peut être obtenu en fabricant d'un seul tenant le support et la structure ou par des moyens intermédiaires venant lier par encastrement la structure au support.

De préférence, le au moins un élément transversal s'étend sur toute la dimension transversale de la couche en matériau piézoélectrique.

Le dispositif comporte avantageusement une pluralité d'éléments transversaux parallèles les uns aux autres et répartis dans la direction longitudinale.

Par exemple, le ou les éléments transversaux présente(nt) une hauteur h dans la direction normale à la direction longitudinale et une largeur La dans la direction longitudinale, le rapport h/La étant supérieur à $10^{-2}$, et de manière préférée supérieur à 1.

Dans un exemple de réalisation, la structure comporte une poutre dont une extrémité longitudinale est encastrée au support, et une autre extrémité longitudinale porte la masse, la au moins une couche en matériau piézoélectrique étant fixée à la poutre.

Dans un exemple de réalisation, la poutre est pleine et les éléments transversaux sont disposés sur la couche en matériau piézoélectrique à l'opposé de la poutre.

Dans un autre exemple de réalisation, la poutre comporte une plaque centrale dont une extrémité longitudinale est encastrée au support, et une autre extrémité longitudinale porte la masse, et les éléments transversaux sont fixés sur au moins une face de la plaque centrale, la au moins une couche en matériau piézoélectrique étant fixée sur les bords des éléments transversaux.

Dans un exemple avantageux, la structure comporte une deuxième couche en matériau piézoélectrique à l'opposé de la première couche en matériau piézoélectrique par rapport à la fibre neutre de la structure.

Dans un exemple préféré, le dispositif comporte des éléments transversaux sur les première et deuxième couches en matériau piézoélectrique disposés en quinconce les uns par rapport aux autres.

Les éléments transversaux peuvent être collés.

Dans un autre exemple de réalisation, les éléments transversaux sont disposés le long de la fibre neutre de la structure et la ou les couches en matériau piézoélectrique et/ou sont fixées sur les bords des éléments transversaux.

Le dispositif peut comporter un circuit électrique connecté aux électrodes et configuré pour collecter les charges électriques produites par la ou les couches en matériau piézoélectrique. Le circuit électrique peut avantageusement comporter un circuit de commande configuré pour appliquer une charge électrique optimale aux bornes de la au moins une couche en matériau piézoélectrique de sorte à fixer la fréquence de résonance de la structure à une valeur donnée.

## BRÈVE DESCRIPTION DES DESSINS

La présente invention sera mieux comprise sur la base de la description qui va suivre et des dessins en annexe sur lesquels :

La figure 1A est une vue en perspective représentée schématiquement d'un exemple de dispositif de récupération d'énergie,

La figure 1B est une vue en coupe longitudinale schématique du dispositif de la figure 1A,

La figure 1C est une vue en perspective d'un exemple d'élément transversal représenté seul,

Les figures 2A et 2B sont des vues de dessus d'un exemple de dispositif de récupération selon l'invention représentant les amplitudes de déformation longitudinale et transversale en niveaux de gris,

Les figures 3A et 3B sont des vues de dessus de dispositif de récupération de l'état de la technique représentant les amplitudes de déformation longitudinale et transversale en niveaux de gris,

La figure 4 est une vue en coupe longitudinale d'une variante de réalisation d'un dispositif de récupération d'énergie,

La figure 5 est une vue en coupe longitudinale d'une autre variante de réalisation d'un dispositif de récupération d'énergie,

La figure 6 est une vue en coupe longitudinale d'un autre exemple de réalisation d'un dispositif de récupération d'énergie,

La figure 7 est une vue en coupe longitudinale d'un autre exemple de réalisation d'un dispositif de récupération d'énergie,

Les figures 8 à 10 représentent des variantes du dispositif de récupération d'énergie de la figure 6.

## EXPOSÉ DÉTAILLÉ DE MODES DE RÉALISATION PARTICULIERS

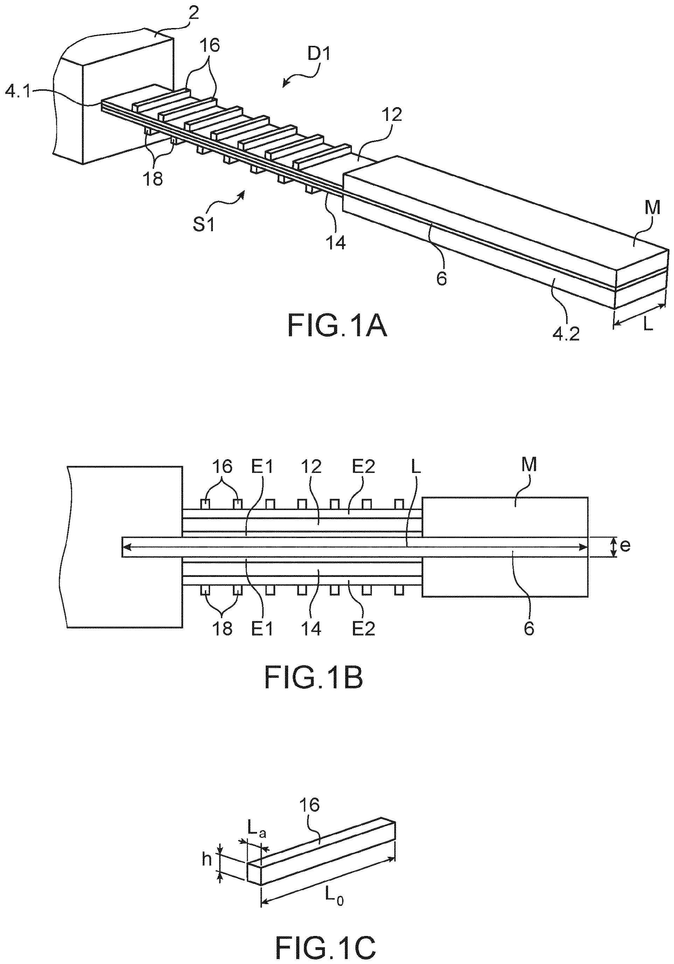

Sur les figures 1A et 1B, on peut voir un exemple de dispositif de récupération d'énergie D1 comportant un support 2 destiné à être fixé à un système connaissant des vibrations, telles qu'un châssis d'un véhicule automobile, une structure S1 encastrée au support 2.

La structure S1 s'étend le long de la direction longitudinale X. Elle comporte une extrémité longitudinale 4.1 encastrée au support et une masse M fixée à son autre extrémité longitudinale 4.2. La structure S1 est destinée à vibrer le long de la direction Z orthogonale à la direction X. Dans cet exemple la masse M s'étend de part et d'autre de la fibre neutre de la structure. En variante elle s'étend au-dessus ou au-dessous de celle-ci.

La structure comporte une poutre 6 qui est encastrée au support et qui porte la masse M. La poutre présente une épaisseur e faible, une largeur L et une longueur l. De préférence, l/e > 5.

La poutre 6 comporte alors deux faces opposées 8, 10 orthogonales à la direction Z.

La structure comporte également des couches en matériau piézoélectrique 12, 14 fixées sur les deux faces 8, 10 opposées de la poutre 6.

Des électrodes E1, E2, représentées sur la figure 1B, de part et d'autre de couche piézoélectrique 12, 14 sont prévues pour collecter les charges générées lors de la déformation des couches et/ou appliquer une polarisation. Les électrodes sont connectées à un circuit électrique C.

De préférence les éléments transversaux sont situés au plus près des couches piézoélectriques, avantageusement en contact avec celles-ci, ou en contact directement avec les électrodes. Sur les figures 1A et 1B, les éléments transversaux 16 sont associés à la couche 12 et ont principalement une action sur celle-ci, et les éléments transversaux 18 sont associés à la couche 14 et ont principalement une action sur celle-ci.

Par exemple, la poutre peut être réalisée en matériau métallique ou alliage, tel que l'acier, le laiton, l'aluminium, en silicium, en matériau polymère tel que époxy.

La masse peut être réalisée en matériau métallique ou alliage, tel que l'acier, le laiton, l'aluminium, le tungstène ou en silicium,

La couche piézoélectrique est par exemple réalisée en PZT (Titano-Zirconate de Plomb), PMN-PT (Plomb-Magnésium-Niobate-Plomb-Titane), PZN-PT (Plomb-Zinc-Niobate-Plomb-Titane), AIN, PVDF (polyfluorure de vinylidène).

Les électrodes sont par exemple en argent, en or ou en cuivre.

Dans l'exemple représenté, la masse est fixée directement sur la poutre et les couches piézoélectriques ne recouvrent que les zones libres des faces 8 et 10.

De préférence, les couches 12 et 14 recouvrent entièrement les zones libres des faces 8 et 10, maximisant la quantité de matériau piézoélectrique et donc la quantité de charges électriques qui peut être générée. Un dispositif dans lequel la ou les couche(s) piézoélectrique(s) ne recouvre(nt) pas entièrement la ou les zones libres de la ou des faces de la poutre ne sort pas du cadre de la présente invention.

Ainsi, lorsque des vibrations sont appliquées au support, la masse suspendue se déplace le long de la direction Z orthogonale à la direction X, déformant en flexion la poutre et les couches 12, 14 générant des charges électriques.

Dans l'exemple représenté, la structure comporte des éléments transversaux 16 fixés sur les électrodes situées le plus à l'extérieur de l'empilement. Les dimensions et/ou la rigidité des éléments transversaux sont choisis pour limiter la déformation transversale de la structure, notamment du matériau piézoélectrique.

Les éléments transversaux 16, 18 s'étendent sur au moins la moitié de la largeur des couches 12, 14. Dans l'exemple représenté et de manière préférée, les couches 12, 14 ont la même largeur que la poutre, mais ceci n'est pas limitatif. Une structure dans laquelle la ou les couches piézoélectriques sont plus larges ou moins larges que la poutre ne sort pas du cadre de la présente invention.

De préférence, les éléments transversaux ont une longueur égale à la largeur des couches 12, 14.

Les éléments transversaux 12, 14 sont de préférence parallèles les uns aux autres et orthogonaux à la direction X réduisant leur effet sur la déformation en flexion de la structure.

Le matériau des éléments transversaux est un matériau présentant une certaine rigidité. A titre d'exemple, les éléments transversaux sont réalisés en cobalt ou en manganèse pour l'utilisation des techniques de dépôt. L'acier ou le laiton permet de réaliser de manière simplifiée de barreaux de plusieurs millimètres de longueur.

Les éléments transversaux présentent une dimension dans la direction Z, désignée hauteur h (figure 1C), suffisante pour offrir une certaine rigidité. De préférence les éléments transversaux ont tous la même hauteur, permettant de simplifier la fabrication.

La largeur La (figure 1C) est choisie pour offrir une certaine rigidité à l'élément transversal sans que celui-ci gêne la déformation en flexion de la structure.

De manière préférée, les matériaux de la poutre et des éléments transversaux sont choisis tels que :

$$\frac{E_{bar}}{E_{piezo}}\frac{L_{tot}}{L_p} < 20$$

$$\frac{Ebar}{Epiezo} = \frac{nombre\ d'éléments\ transversaux\ \times longueur\ d'un\ élément\ transversal}{Lp} < 20$$

Avec :

E bar : module de Young des éléments transversaux,
E piezo : module de Young de la couche piézoélectrique,

Lp : longueur de la poutre,

Ltot : somme des longueurs des éléments transversaux,

Nbre barres : le nombre d'éléments transversaux,

« longueur barre » : la longueur d'un élément transversal.

De plus, les hauteurs des éléments transversaux et l'épaisseur de la couche piézoélectrique peuvent être avantageusement choisies telles que :

$$\frac{E_{bar}}{E_{piezo}} * \left(\frac{h_{bar}}{h_{piezo}}\right)^3 > 10^{-3}$$

Avec :

hbar = épaisseur des éléments transversaux,

hpiezo : épaisseur de la couche piézoélectrique.

L'épaisseur de la poutre peut également être avantageusement est choisie telle que :

$$\frac{E_{bar}}{E_{moy}} * \left(\frac{h_{bar}}{epaisseur\ poutre}\right)^3 > 27.10^{-3}$$

Avec :

Emoy = (épaisseur de la couche piézoélectrique x Epiezo + épaisseur poutre x Epoutre)/Eptotale

Epoutre étant le module d'Young de la poutre Eptotale étant l'épaisseur totale de la poutre qui est égale à la somme : épaisseur de la couche piézoélectrique + épaisseur de la poutre.

Le rapport h/La est au moins égal à $10^{-2}$, de préférence au moins égal à $2.10^{-1}$ et de manière préférée supérieur à 1.

L'élément transversal a une longueur Lo.

En outre le nombre d'éléments transversaux et leur répartition le long de la direction X permettent également d'ajuster leur effet sur la limitation de la déformation transversale de la structure.

Dans l'exemple représenté les éléments transversaux 16, 18 sur les couches 12, 14 de part et d'autre de la poutre sont répartis en quinconce. Cette répartition est particulièrement avantageuse lorsque le nombre d'éléments transversaux est réduit. En effet les éléments transversaux 16 ainsi répartis peuvent avoir un effet sur la couche 14 même si celui-ci est réduit par rapport à l'effet qu'ils ont sur la couche 12. La limitation de la déformation transversale est alors répartie au mieux selon la longueur de la poutre

Dans cet exemple, les éléments transversaux sont répartis sur toute la longueur des couches 12, 14 et de manière uniforme.

De préférence, la distance entre deux faces parallèles en regard de deux éléments transversaux adjacents est supérieure à La, la largeur des éléments transversaux

Les éléments transversaux peuvent présenter des dimensions différentes les uns des autres, par exemple en fonction de leur disposition par rapport à la zone d'encastrement.

La mise en œuvre de couches en matériau piézoélectrique de part et d'autre de la fibre neutre de la poutre permet d'optimiser la récupération d'énergie. Il sera compris qu'une structure comportant une seule couche en matériau piézoélectrique ne sort pas du cadre de la présente invention.

La structure vibrante présente une fréquence de résonance Fr1, qui est fixée par les dimensions des différents éléments de la structure, leurs dimensions et propriétés mécanique. C'est la fréquence à laquelle la structure présente le plus d'énergie récupérée.

De préférence, le dispositif comporte un circuit de commande CC de la fréquence de résonance de la structure permettant d'ajuster la fréquence de résonance mécanique de la structure.

Par exemple le circuit de commande comporte une charge électrique d'impédance réglable. En fonction de la fréquence de résonance mécanique souhaitée, le circuit de commande CC adapte l'impédance connectée aux bornes des électrodes. En effet en modifiant les conditions électriques du matériau piézoélectrique, celui-ci se raidit ou s'assouplit ; ce qui modifie la fréquence de résonance de la structure. De manière avantageuse, le circuit de commande fixe la fréquence de résonance mécanique de la structure pour qu'elle soit proche de ou égale à la fréquence de vibration du système.

De préférence, la fréquence de résonance mécanique est choisie de sorte que :

$$|\text{Fréquence Résonance - Fréquence vibration}|/(\text{Fréquence vibration}) < 5\%.$$

Par exemple, un système automatisé de suivi de fréquence peut être mis en œuvre pour gérer la fréquence de résonance mécanique. Cette capacité d'ajuster la fréquence de résonance est d'autant plus grande que le coefficient de couplage électromécanique est grand. Ainsi, grâce à l'invention, le dispositif peut être adapté à des environnements vibrant à des fréquences variées tout en conservant une puissance récupérée élevée.

À titre d'illustration de l'effet de l'invention, les déformations longitudinale et transversale de différentes structures et le gain en couplage ont été estimés par simulations aux éléments finis, par exemple à l'aide du logiciel COMSOL®.

La structure considérée est celle de la figure 1A. Les structures considérées sont les suivantes : contrairement à la structure de la figure 1A, elle comporte une couche piézoélectrique 12 avec des éléments transversaux fixés à cette couche :

Les couches 12 et 14 sont en matériau piézoélectrique : PMN-PT orienté en [001]. Les électrodes étant très fines, par exemple d'épaisseur au moins 10 fois plus faible que l'épaisseur du matériau piézoélectrique, leur effet est négligeable.

Les couches piézoélectriques 12, 14 ont une longueur de 45 mm, une largeur de 10 mm et une épaisseur de 0,5 mm.

La masse en acier a une longueur de 45 mm, une largeur de 10 mm et une épaisseur de 5 mm.

La poutre en acier a une longueur de 45 mm, une largeur de 10 mm et une épaisseur de 0,5 mm.

14 éléments transversaux en acier de longueur l = 10 mm, de hauteur h = 1 mm et de largeur L = 1 mm, répartis de part et d'autre de la fibre neutre de la poutre.

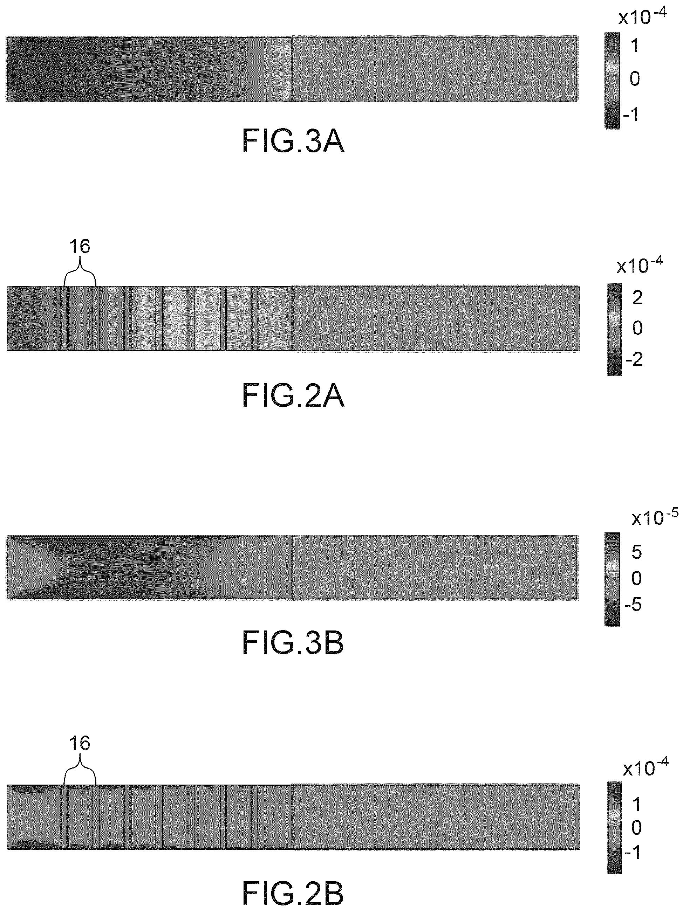

Sur les figures 2A et 2B, on peut voir représentées la déformation longitudinale et la déformation transversale respectivement d'une structure selon l'invention, i.e. munie d'éléments transversaux. L'amplitude de la déformation est représentée en niveau de gris. On constate que la structure présente peu de déformation transversale. Le coefficient de couplage électromécanique pour cette structure est égal à 37,71%. L'échelle sur la figure 2A correspond au rapport ∆l/l et l'échelle sur la figure 2B correspond au rapport ∆L/L.

À titre de comparaison, sur les figures 3A et 3B, on peut voir représentées la déformation longitudinale et la déformation transversale respectivement d'une structure de l'état de la technique, i.e. sans élément transversal et présentant les dimensions ci-dessus. Le coefficient de couplage électromécanique de la structure de l'état de la technique est égal à 21,34%. L'amplitude de la déformation est représentée en niveau de gris. L'échelle sur la figure 3A correspond au rapport ∆l/l et l'échelle sur la figure 3B correspond au rapport ∆L/L.

On constate que la structure selon l'invention présente une déformation transversale sensiblement réduite par rapport à celle de la structure de l'état de la technique tout en présentant une déformation longitudinale sensiblement identique. En outre le coefficient de couplage électromécanique est multiplié par 1,75 grâce à l'invention, alors que la fréquence de résonance en circuit fermé est peu modifiée.

Dans l'exemple représenté, plusieurs éléments transversaux sont mis en œuvre. Cependant une structure avec un élément transversal sur chaque couche 12, 14 présente un coefficient de couplage électromécanique multiplié par 1,25 par rapport à celui d'une structure de l'état de la technique.

Par exemple, les éléments transversaux sont rapportés sur la structure. Par exemple ils sont collés sur la structure.

En variante, les éléments transversaux sont réalisés suivant les techniques de la microélectronique, i.e. par dépôt de couche et structuration, par exemple par gravure.

Le fonctionnement du dispositif de récupération D1 va être décrit.

Lorsque le système auquel est fixé le support du dispositif subit des vibrations, la masse suspendue M se déplace le long de la direction Z, déformant la poutre et les couches piézoélectriques en flexion qui est mise en vibration. Cette déformation provoque la génération de charges électriques qui sont collectés et transmises au circuit électrique C. Si les vibrations subies par le système sont proches de la fréquence de résonance Fr1 de la structure, la récupération est optimale. La génération de charges électriques est d'autant plus grande que la déformation longitudinale de la structure est grande.

De préférence, le circuit de commande CC ajuste préalablement la fréquence de résonance mécanique de la structure de sorte qu'elle soit proche de la ou des fréquences des vibrations à récupérer.

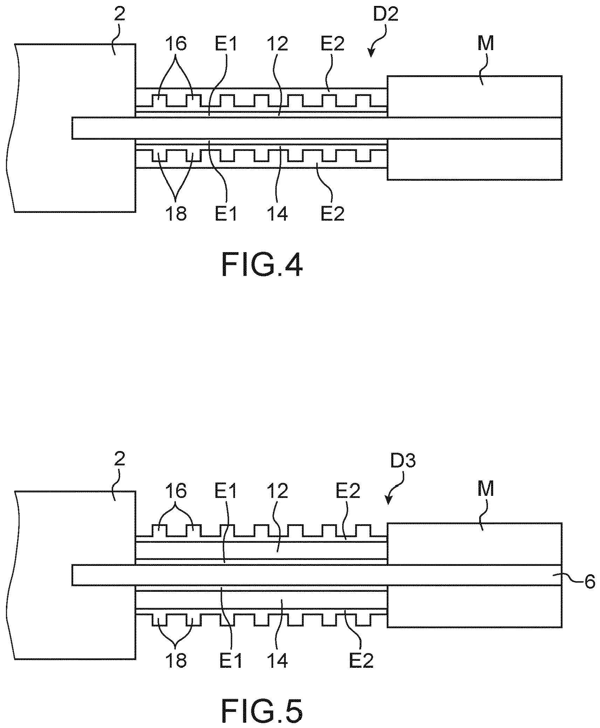

Sur la figure 4, on peut voir une variante de réalisation D2 dans laquelle les éléments transversaux 16, 18 sont en matériau piézoélectrique et réalisés d'un seul tenant avec les couches 12, 14.

Sur la figure 5, on peut voir une autre variante de réalisation D3, dans laquelle ce sont les électrodes E2 qui sont structurées pour intégrer les éléments transversaux 16, 18.

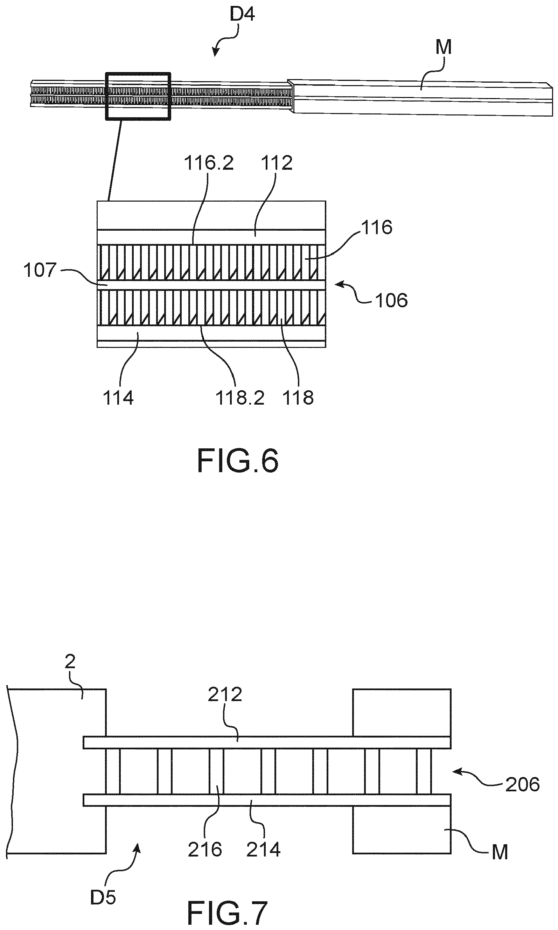

Sur la figure 6, on peut voir un autre exemple de réalisation D4 dans lequel c'est la poutre qui porte les éléments transversaux. La poutre 106 comporte une plaque centrale 107 et des éléments transversaux 116, 118 sur ses deux faces opposées, fixés à la plaque 107 par un bord latéral 116.1, 118.1, avantageusement disposées en quinconce. Les couches piézoélectriques 112, 114 et leurs électrodes sont fixées sur l'autre bord latéral 116.2, 118.2 de chaque élément transversal.

Par exemple les éléments transversaux sont réalisés par structuration d'un substrat par les techniques de la microélectronique. Les couches piézoélectriques et les électrodes sont réalisées par dépôt.

En variante, les éléments transversaux sont rapportés un à un sur la plaque centrale 107, ce qui permet d'utiliser un matériau plus rigide pour fabriquer les éléments transversaux par rapport au matériau de la plaque centrale qui est destinée à se déformer en flexion.

Sur la figure 7, on peut voir un autre exemple D5 dans lequel la poutre 206 est formée uniquement par des éléments transversaux 216, les couches en matériau piézoélectrique 212, 214 étant fixées sur les bords des éléments transversaux 216.

Selon une variante de la figure 7, des éléments transversaux sont rapportés également sur la face extérieure des couches piézoélectriques 212, 214.

Dans les exemples décrits ci-dessus, les éléments transversaux présentent une section transversale rectangulaire ou carrée. D'autres formes sont également envisageables. Ils peuvent présenter une section trapézoïdale, par exemple orientés de sorte que la petite base soit du côté de la poutre.

La poutre 6 peut avoir toute forme s'étendant principalement dans la direction longitudinale, par exemple une forme ondulé ou en zigzag.

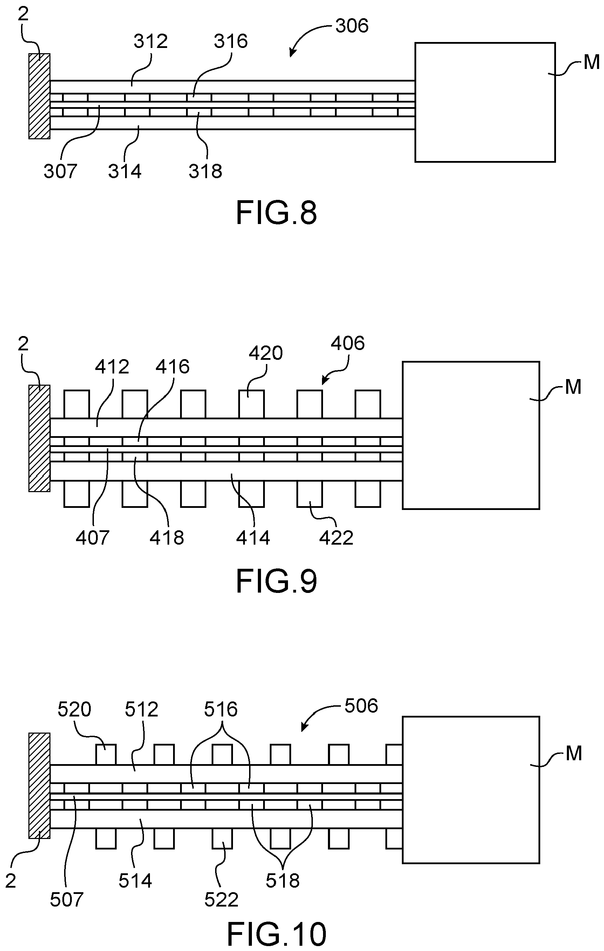

Les figures 8 à 10 représentent des variantes du dispositif de la figure 6.

Sur la figure 8, la poutre 306 comporte une plaque centrale 307 et des éléments transversaux 316, 318 sur ses deux faces opposées, fixés à la plaque 307 par un bord latéral. Les couches piézoélectriques 312, 314 et leurs électrodes sont fixées sur l'autre bord latéral de chaque élément transversal. Dans cette variante, chaque élément transversal 316 est aligné avec un élément transversal 318 dans une direction orthogonale à la direction longitudinale de la poutre.

Sur la figure 9, la poutre 406 comporte une plaque centrale 407 et des éléments transversaux 416, 418 sur ses deux faces opposées, fixés à la plaque 407 par un bord latéral. Les couches piézoélectriques 412, 414 et leurs électrodes sont fixées sur à l'autre bord latéral de chaque élément transversal. La poutre 406 comporte également des éléments transversaux 420 fixés sur la face extérieure de la couche piézoélectrique 412, située à l'opposé de la face de couche piézoélectrique en contact avec les éléments transversaux 416. La poutre 406 comporte également des éléments transversaux 422 fixés sur la face extérieure de la couche piézoélectrique 414. Dans cette variante, chaque élément transversal 416 est aligné avec un élément transversal 418, un élément transversal 420 et un élément transversal 422 dans une direction orthogonale à la direction longitudinale de la poutre.

Sur la figure 10, la poutre 506 comporte une plaque centrale 507 et des éléments transversaux 516, 518 sur ses deux faces opposées, fixés à la plaque 507 par un bord latéral. Les couches piézoélectriques 512, 514 et leurs électrodes sont fixées sur à l'autre bord latéral de chaque élément transversal. La poutre 506 comporte également des éléments transversaux 520 fixés sur la face extérieure de la couche piézoélectrique 512. La poutre 506 comporte également des éléments transversaux 522 fixés sur la face extérieure de la couche piézoélectrique 514. Dans cette variante, chaque élément transversal 516 est aligné avec un élément transversal 518, dans une direction orthogonale à la direction longitudinale de la poutre, et chaque élément transversal 520 est aligné avec élément transversal 522 dans la direction orthogonale à la direction longitudinale de la poutre. Les éléments transversaux 516, 518 sont disposés en quinconce par rapports aux éléments transversaux 520, 522.

Dans une variante non représentée, les éléments 516, 518, 520, 522 sont disposés en quinconce les uns par rapport aux autres.

Le nombre de couche de matériau piézoélectrique peut être supérieur à 2 et le nombre de jeu d'éléments transversaux peut être supérieur à 4.

Le dispositif comporte au moins n couche(s) en matériau piézoélectrique, n étant au moins égal à 1 et au moins un élément transversal solidaire d'au moins une des couches. En effet un dispositif avec trois couches en matériau piézoélectrique et des éléments transversaux associés à une couche entre dans le cadre de la présente invention.

Grâce à l'invention, on réalise un dispositif qui peut être commandé pour permettre une récupération d'énergie optimisée sur une large gamme de fréquence.

Le dispositif est de réalisation relativement aisée, notamment par des procédés microélectroniques.

On peut envisager un système comportant plusieurs dispositifs de récupération comprenant des structures avec des fréquences de résonance différentes, ce qui permet de couvrir une gamme de fréquence encore plus large.

**Revendications**

1.  Dispositif de conversion d'énergie mécanique en énergie électrique comportant un support (2), une structure s'étendant selon une direction longitudinale (X), ladite structure étant suspendue au support par encastrement par une première extrémité longitudinale et comportant une masse (M) fixée à une deuxième extrémité longitudinale, au moins une couche en matériau piézoélectrique (112, 114) s'étendant au moins en partie entre la première extrémité longitudinale et la deuxième extrémité longitudinale de la structure et disposée de sorte que, lorsque la masse (M) bouge dans une direction orthogonale à la direction longitudinale, la couche est déformée en flexion, des électrodes de part et d'autre de la couche en matériau piézoélectrique (112, 114), dans lequel la structure comporte des éléments transversaux (116, 118) solidaires de la couche en matériau piézoélectrique (112, 114) s'étendant transversalement par rapport la direction longitudinale (X) sur une longueur au moins égale à la moitié de la dimension transversale (L) de la couche en matériau piézoélectrique, ladite structure comportant également une poutre comprenant une plaque centrale dont une extrémité longitudinale est encastrée au support, et une autre extrémité longitudinale porte la masse, et dans lequel les éléments transversaux (116, 118) sont fixés sur au moins une face de la plaque centrale, la au moins une couche en matériau piézoélectrique (112, 114) étant fixée sur les bords des éléments transversaux.

2.  Dispositif selon la revendication 1, dans lequel les éléments transversaux (116, 118) s'étendent sur toute la dimension transversale de la couche en matériau piézoélectrique (112, 114).

3.  Dispositif selon la revendication 1 ou 2, comportant une pluralité d'éléments transversaux (116, 118) parallèles les uns aux autres et répartis dans la direction longitudinale (X).

4.  Dispositif selon la revendication 3, dans lequel les éléments transversaux (116, 118) présentent une hauteur dans la direction normale (Z) à la direction longitudinale (X) et dans lequel tous les éléments transversaux ont la même hauteur.

5.  Dispositif selon l'une des revendications 1 à4, dans lequel les éléments transversaux (116, 118) présentent une hauteur h dans la direction normale (Z) à la direction longitudinale (X) et une largeur La dans la direction longitudinale, le rapport h/La étant supérieur à $10^{-2}$, et de manière préférée supérieur à 1.

6.  Dispositif selon l'une des revendications 1 à 5, dans lequel la structure comporte une deuxième couche en matériau piézoélectrique (114) à l'opposé de la première couche en matériau piézoélectrique (112) par rapport à la fibre neutre de la structure.

7.  Dispositif selon la revendication 6, comportant des éléments transversaux (116, 118) sur les première et deuxième couches en matériau piézoélectrique disposés en quinconce les uns par rapport aux autres.

8.  Dispositif selon l'une des revendications 1 à 7, dans lequel les éléments transversaux sont collés.

9.  Dispositif selon l'une des revendications 1 à 8, comportant un circuit électrique (C) connecté aux électrodes (E1, E2) et configuré pour collecter les charges électriques produites par la ou les couches en matériau piézoélectrique (12, 14).

10.  Dispositif selon la revendication 9, dans lequel le circuit électrique comporte un circuit de commande (CC) configuré pour appliquer une charge électrique optimale aux bornes de la au moins une couche en matériau piézoélectrique de sorte à fixer la fréquence de résonance de la structure à une valeur donnée.

FIG.1A

FIG.1B

FIG.1C

FIG.3A

16

FIG.2A

FIG.3B

16

FIG.2B

FIG.4

FIG.5

FIG.6

FIG.7

FIG.8

FIG.9

FIG.10

Europäisches
Patentamt

European
Patent Office

Office européen
des brevets

# RAPPORT DE RECHERCHE EUROPEENNE

Numéro de la demande

EP 20 19 6518

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2013/342075 A1 (SEDDIK BOUHADJAR AHMED [FR] ET AL) 26 décembre 2013 (2013-12-26) | 1-3,5-10 | INV. H02N2/18 H01L41/113 |
| A | * alinéa [0043] - alinéa [0044]; figure 1 * | 4 | |
| A | US 2018/262130 A1 (OKADA KAZUHIRO [JP] ET AL) 13 septembre 2018 (2018-09-13) * alinéa [0075] - alinéa [0194]; figure 8 * | 1-10 | |

**DOMAINES TECHNIQUES RECHERCHES (IPC)**

H01L
H02N

Le présent rapport a été établi pour toutes les revendications

| Lieu de la recherche | Date d'achèvement de la recherche | Examinateur |
|---|---|---|
| Munich | 3 décembre 2020 | Koskinen, Timo |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 20 19 6518

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

03-12-2020

| Document brevet cité au rapport de recherche | Date de publication | Membre(s) de la famille de brevet(s) | Date de publication |
|---|---|---|---|
| US 2013342075 A1 | 26-12-2013 | EP 2673873 A1<br>FR 2971650 A1<br>JP 2014511664 A<br>US 2013342075 A1<br>WO 2012107327 A1 | 18-12-2013<br>17-08-2012<br>15-05-2014<br>26-12-2013<br>16-08-2012 |
| US 2018262130 A1 | 13-09-2018 | CN 108028614 A<br>JP 6241981 B1<br>JP WO2017208467 A1<br>US 2018262130 A1<br>WO 2017208467 A1 | 11-05-2018<br>06-12-2017<br>14-06-2018<br>13-09-2018<br>07-12-2017 |

EPO FORM P0460

Pour tout renseignement concernant cette annexe : voir Journal Officiel de l'Office européen des brevets, No.12/82